# EUROPEAN PATENT SPECIFICATION

(11) **EP 2 868 768 B1**
(45) Date of publication and mention of the grant of the patent: **16.06.2021**
(21) Application number: 13005128.7
(22) Date of filing: 29.10.2013
(51) Int. Cl.: C23C 14/22, C23C 14/50

(54) **Shutter system**
Verschlussvorrichtung
Système d'obturation

(43) Date of publication of application: 06.05.2015
(73) Proprietor: Oerlikon Surface Solutions AG, Pfäffikon, 8808 Pfäffikon (CH)
(72) Inventor: Kurapov, Denis, 8880 Walenstadt (CH)
(74) Representative: Kempkens, Anke

(56) References cited:
- US-A- 4 953 498
- US-A1- 2009 236 218
- US-A1- 2011 305 833
- US-B1- 6 315 877

## Description

The present invention relates to an apparatus for treating and/or coating substrate surfaces having a substrate shutter system which allows a better economical utilization of the apparatus as well as a more versatile buildup of multilayer coating structures.

### State of the art

Several kind of substrates are been treated nowadays by using plasma treatments and/or plasma coating processes in order to provide special surface properties to the substrates, which makes the use of new technologies possible.

Particularly, the use of physical vapor deposited coatings (PVD coatings) for improving tools and components performance of for example cutting and forming tools as well as automotive and decorative components, is in great demand today.

For this reason, several vacuum coating apparatus have been developed in the last years which allow coating of a high quantity of tools and/or components in the industrial context. However, it remains a challenge the construction of suitable coating apparatus which allows depositing complex structured coatings (for example, having multilayer structures with defined individual layer thickness) and maintaining high economical utilization of the coating apparatus at the same time.

Typical coating apparatus have been constructed having one treatment chamber which offers space for multiple substrate carriers and coating sources and/or treatment units (e.g. heater, etching device, etc.).

Typically, in a PVD process at least a part of the coating material which condenses on the substrate surface from the gas phase for forming the PVD film is generated from a solid material source (e.g. a solid target in the case of arc and sputtering processes or powder material in a crucible in the case of ion beam processes).

In order to avoid undesirable deposition of material generated from the solid material source on the substrate surfaces to be coated, movable shutter elements are commonly arranged in the interior of the treatment chamber. These kind of shutter systems can be designed in such a manner that the shutter elements can be placed arbitrarily between the solid material source and the substrates or be removed before, during or after film deposition according to the design of the coating process and/or according to the coating architecture which should be exhibited by the deposited films, e.g. regarding coating composition, coating structure (monolayer or multilayer), thickness of the individual layers, etc. Some of the today currently used shutter systems in this context according to the state of the art are for example described in the patent documents US7905991B2, WO2012152642 and GB979700A. US2009236218, US6315877 and US4953498 are also relevant prior art documents.

US7905991B2 describes vacuum treatment apparatus comprising a target shutter arrangement for covering a target having a flat surface, in which, when the shutter covers the target, the distance between the shutter and the target overlap, thus permitting, on one hand, the ignition and operation of a magnetron or a cathode spark discharge behind the target and, on the other hand, preventing the ignition of an auxiliary plasma with the target turned off.

WO2012152642 describes a PVD coating apparatus comprising at least two lateral rotating arc cathodes with targets equipped with rotary shields, as shutters. The shutters are rotatable steel sheets used as shields between the cathodes and the substrates. These shutters are fundamentally used for avoiding that material evaporated from the target during ignition of the arc at the cathode can be deposited ontp the substrates producing contamination of the substrates.

GB979700A described an ion beam PVD coating apparatus, in which more than one crucible containing different coating materials are used for producing different coating layers, the crucibles being rotatable mounted in order to be moved in such a manner that each crucible can be selected for being into the path of the electron beam. Furthermore, the apparatus comprising a movable shutter located between the crucibles and the substrate in the flow path of the vapor for blocking the flow of coating material onto the substrate selectively without blocking the electron beam.

In the industrial production context it is also necessary to attain the major profitability. For this reason, currently commercial available coating apparatus for the industrial coating production are constructed for offering a treatment chamber with space for multiple substrate carriers and coating sources and/or treatment units (e.g. heater, etching device, etc.). However, by using these apparatus it is only possible to coat the in one batch charged substrates only with a single type of coating, even if this type of coating exhibits a multilayer architecture or another kind of complex architecture.

Moreover, current available coating apparatus must often be operated without using the full substrate load capacity of the coating apparatus. It happens when for example there are two or more different types of substrates or the same kind of substrates but to be used in different kind of applications, which need to be covered in fact with the same type of coating but having different layer thickness or different layer thickness ratio within the coating architecture, or in cases in which for example it is necessary to deposit similar kind of coatings in the different substrates but the coatings differing in their architecture, for example differing in the deposition of one or more layers.

In the above mentioned cases all the substrates cannot be coated in the same batch and for this reason often several batches must be conducted without using the full substrate load capacity. Hence, the coating apparatus is operated inefficiently.

Since the highest percentage of processing time by operation of a treatment and/or coating apparatus comprises the steps before and after coating (heating, etching and cooling of substrates and substrates carriers) conducing more than one batch in these cases can be very time and cost consuming which implicates low profitability.

The patent document US20110305833A1 provides an apparatus for treating and/or coating substrates, which is equipped with a treatment chamber comprising different modules at the same time, having the same atmosphere but separated physically with shutters in such a way that different groups of substrates can be placed in the different modules and each group of substrates placed in a respective module can be treated and/or coated by using PVD methods independently during the conduction of the same batch. In this way, this kind of treating and/or coating apparatus should help to minimize processing and delivery times. However, the construction and operation of such kind of apparatus can be very complex and expensive. Furthermore the operation of the apparatus seems to involve many process complications and instabilities.

### Objective of the present invention

It is an objective of the present invention to provide an industrial coating apparatus which overcomes the above mentioned limitations of the state of the art, particularly in such a way that allows operating the coating apparatus efficiently.

Furthermore, it is an objective of the present invention to provide a simple method for coating different groups of substrates in a same batch but in such a way that each group of substrates can be coated with a coating film having different features which are adjusted arbitrarily, particularly for example regarding thickness of the deposited film or thickness of the deposited individual layers in the case of deposition of coatings having a multilayer architecture, or also regarding quantity of individual layers constituting the deposited coating film.

### Description of the invention

The aforementioned objective is achieved by the present invention by providing a treatment and/or coating apparatus (in the following simply referred to as apparatus) according to claim 1.

An apparatus according to the present disclosure comprises a treatment chamber (in the following simply referred to as chamber), in which substrates having a surface to be treated (e.g. etched or coated) are arranged in at least one substrate holding system placed inside of the chamber, wherein at least one source for producing surface treatment agents (e.g. a target used as material source) is arranged in the interior of the chamber which can be activated (e.g. the target can be operated as cathode) in order to produce the necessary treatment agents (e.g. etching ions or coating material) for carrying out one or more surface treatments on the substrates arranged in the interior of the chamber, wherein the substrate holding system comprises at least one shutter system comprising at least one movable shutter element to be arranged around of at least a portion of the holder system for shielding at least some of the substrates arranged in the holding system in such a manner that the surface of the shielded substrates cannot be treated during the execution of the one or more surface treatments or at least during a part of the execution of the one or more surface treatments because the movable shutter element interrupts at least partially or avoid completely the surface treatment of the shielded substrates.

In the context of the present invention the expression "shielded substrates" is used for referring to the substrates which are at least partially or preferably completely covered with the movable shutter element in such a manner that the movable shutter element is positioned between the source and the substrates interrupting at least partially or preferably avoiding completely the flow of treatment agents to the surface of the covered substrates during the execution of one or more surface treatments or at least during a part of the execution of one or more surface treatments.

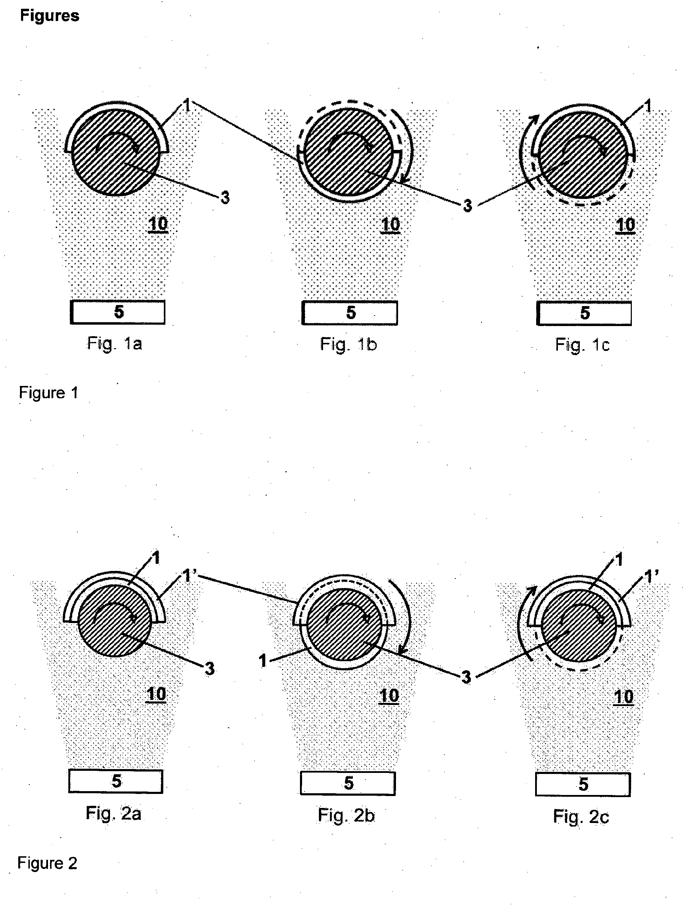

In order to explain the invention in more detail, some preferred embodiments of the present invention will be described. Likewise, the figures 1 to 7 will be used for attaining a better understanding of the present invention. However, the present invention should not be limited by the preferred embodiments and figures described in the following.

Figure 1 (a, b, c) shows a view from above of a schematic representation of an arrangement in the interior of the chamber of a preferred embodiment of an apparatus according to the present disclosure. The substrate holding system 3 in this case is positioned in front of the material source 5 and rotates itself (turns around). The substrate holder system 3 can be for example a cylindrical holder tree having a circular transversal section as it is drawn in figure 1. According to this preferred embodiment of the invention, the shutter system comprises one movable shutter element 1 which is preferably a single rotatable shutter element having a half tube form which preferably allows covering at least an extension of 180° of the transversal section of the substrate holder system 3. The substrates having a surface to be treated (don't drawn in figure 1) are held in the holder tree 3 in such a manner, that if the holder tree remains in front of the source 5 but rotates on its own axis (turns around on its own axis) the held substrates will be only temporarily in front of the target during the rotation of the holder tree 3. Then the shutter element 1 can be moved around the holder tree 3 to be placed in at least two basic positions irrespective of the holder tree 3 is rotating or no, an open position (as it is shown in fig. 1a and fig. 1c) and a closed position (as it is shown in fig. 1b), so that:
- when the movable shutter element 1 is positioned in the open position, the substrates (not drawn in fig. 1a and fig. 1c) held in the holder tree 3 can be treated during the time at which they are in front of the material source 5, and
- when the movable shutter element 1 is positioned in the closed position, the substrates (not drawn in fig. 1b) held in the holder tree 3 cannot be treated because at the time during the rotation of the holder tree 3 at which they are in front of the material source 5, the movable shutter element 1 impedes the flow of the treatment agent 10 (e.g. plasma ions) from the source 5 to the shielded substrates.

Figure 2 shows the present invention, in which the shutter system comprises two shutter elements 1 and 1'. In this case, the holder system 3 can be also a cylindrical holder tree having a circular transversal section. Each one of the shutter elements 1 and 1' can have a half tube form, and preferably each one of the shutter elements can cover an extension of 180 ° of the transversal section of the holder tree 3, so that it is possible to cover the holder tree 3 completely (it is possible to cover 360 ° of the transversal section of the holder tree 3) as it is shown in fig. 2b. Like in the embodiment described before, the holder tree 3 can remain in front of the source 5 and rotate on its own axis (turns around on its own axis) in such a manner that the held substrates can be only temporarily in front of the target during the rotation of the holder tree 3. According to this embodiment at least one of the shutter elements is movable around the holder tree. Preferably, both of the shutter elements are movable around the holder tree, so that the shutter elements can be moved for being positioned in at least two basic positions irrespective of the motion of the holder tree 3, an open position (as it is shown in fig. 2a and fig. 2c) and a closed position (as it is shown in Fig. 2b). For better understanding of the description, irrespective of the motion of the holder tree 3, the part of the holder tree 3 facing the source 5 will be referred to the front side of the holder tree 3 and the part of the holder tree 3 not facing the source 5 will be referred to the back side of the holder tree 3. During the time that the shutter elements are placed in the open position (as it is shown in fig. 2a and fig. 2c), both shutter elements 1 and 1' are placed in the back side of the holder tree allowing the surface treatment of the substrates held in holder tree 3 which are facing at least temporally the source 5. During the time that the shutter elements are placed in the closed position (as it is shown in fig. 2b), one of the shutter elements is covering 180 ° of the total transversal section of the holder tree 3 and the another shutter element is covering the remaining 180 °, so that the 360 ° corresponding to the complete transversal section of the holder tree covered and consequently all substrates held in the holder tree 3 are shielded. For instance in figure 2, the shutter element 1' is placed in the back side of the holder tree 3 when the shutter system is arranged to be in the open position (fig. 2a and fig. 2c) as well as in the closed position (fig. 2b) irrespective of the motion of the holder tree 3. Whereas, the shutter element 1 is placed in the back side of the holder tree 3 during the time that the apparatus must be operated in the open position (fig. 2a and 2c) allowing surface treatment of the substrates arranged (at least temporarily) in the front side of the holder tree 3, and is placed in the front side of the holder tree 3 during the time that the apparatus must be operated in the closed position (fig. 2b) impeding surface treatment of the substrates arranged (at least temporarily) in the front side of the holder tree 3.

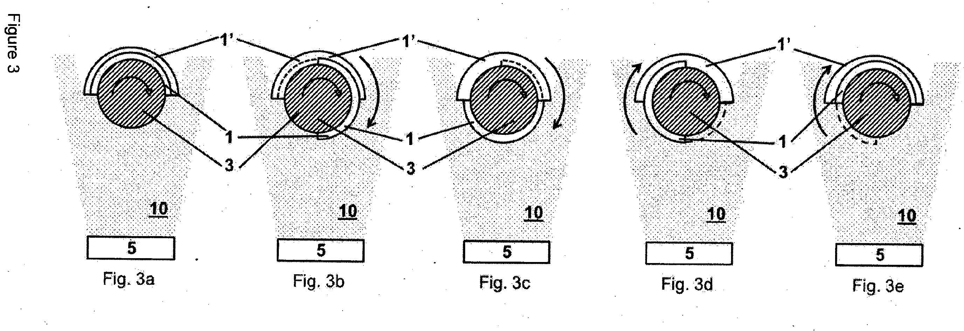

One more preferred embodiment of the present invention is given by using a shutter system comprising two shutter elements 1 and 1' in a similar way like in the embodiment shown in figure 2; but in this case the movable shutter elements 1 and 1' can be moved in such a manner that it is not only possible to place the shutter elements for operating the apparatus in two positions but in at least three positions or more. Figure 3 shows an example of an apparatus with a shutter system arrangement according to this embodiment of the present invention. In fig. 3a and fig. 3e it is shown the arrangement corresponding to the open position, and in fig. 3c it is shown the arrangement in the closed position, these two arrangements are similar like in the embodiment described before. However, according to this third embodiment of the present invention the shutter elements can be moved in order to operate the apparatus in different semi-open positions like those shown in fig. 3b and fig. 3d. These semi-open positions could be used for example if it is intended to attain a reduced surface treatment rate (e.g. a reduced etching rate or a reduced film deposition rate) for all or for some of the substrates held in the holder tree 3.

An apparatus according to the present invention is not limited by the preferred embodiments described above and can for example (depending on the purposes of the operator or a person skilled in the art) comprise a shutter system arrangement comprising more than 2 movable shutter elements which can cover different extensions of the substrate holding system.

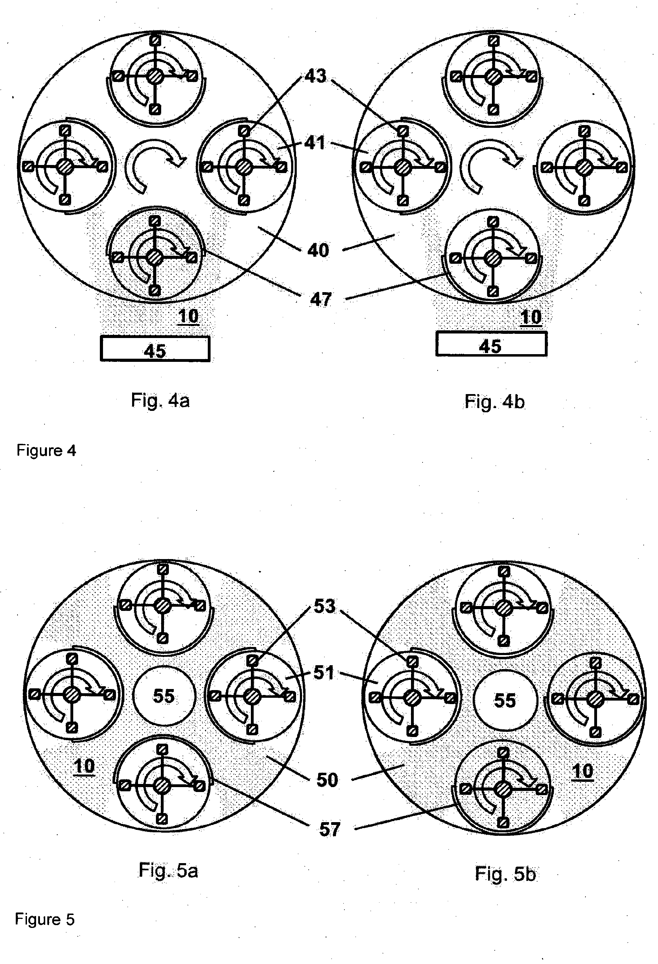

Figure 4 shows a view from above of a schematic representation of two possible arrangements (fig. 4a and fig. 4b) of the interior of a chamber (e.g a vacuum chamber) of a surface treatment apparatus according to the present invention which comprises one surface treatment source 45, e.g. an arc or sputtering target placed in a lateral area of the chamber (not drawn in figure 4), a substrate holding system comprising a carrousel 40 with 4 holder trees 41, where the substrates 43 to be treated can be held. Each holder tree 41 comprising a shutter system 47 having one or more movable shutter elements according to the present invention for allowing (fig. 4a bottom) or avoiding (fig. 4a left side, right side and top, and fig. 4b) or allowing partially (not shown in figure 4 but in a similar way like it is for instance shown in fig. 3b and fig. 3d) surface treatment of the substrates 43 held in each holder tree 41 (it means for allowing or avoiding or allowing partially the flow of the treatment agents 10 from the source 45 to the substrates 43), respectively, according to the purposes of the operator. Preferably, the apparatus represented in figure 4 comprises more than one surface treatment source 45.

Figure 5 shows a view from above of a schematic representation of two possible arrangements (fig. 5a and fig. 5b) of the interior of a chamber (e.g. a vacuum chamber) of one more surface treatment apparatus according to the present invention which comprises one surface treatment source 55, e.g. an arc or sputtering target placed in the central area of the chamber (not drawn in figure 5), a substrate holding system comprising a carrousel 50 with 4 holder trees 51, where the substrates 53 to be treated can be held. Each holder tree 51 comprising a shutter system 57 having one or more movable shutter elements according to the present invention for allowing (fig. 5b, bottom) or avoiding (fig. 5a, fig. 5b left side and fig. 5b top) or allowing partially (fig.,5b right side) surface treatment of the substrates 53 held in each holder tree 51 (it means for allowing or avoiding or allowing partially the flow of the treatment agents 10 from the source 55 to the substrates 53), respectively, according to the purposes of the operator.

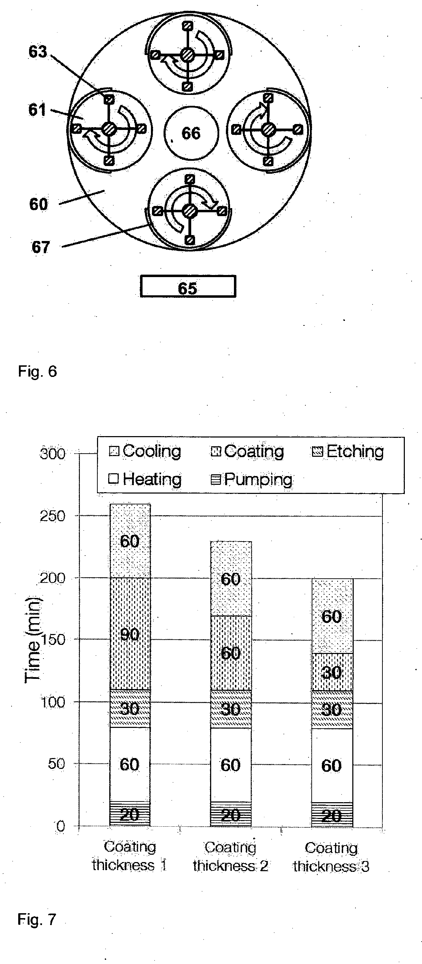

Figure 6 shows a view from above of a schematic representation of a possible arrangements of the interior of a chamber (e:g. a vacuum chamber) during an heating process carried out in an apparatus according to the present invention which comprises a heater 66 (for example for heating the substrates 63 before beginning the surface treatment) placed in the central area of the chamber (not drawn in figure 6), a surface treatment source 65, e.g. an arc or sputtering target placed in a lateral area of the chamber (the source 65 is not activated in figure 6), and a substrate holding system comprising a carrousel 60 with 4 holder trees 61, where the substrates 63 to be treated can be held. Each holder tree 61 comprises a shutter system 67 having one or more movable shutter elements according to the present invention. In this case the shutter elements of the shutter system 67 are arranged in an open position regarding the heater, so that the substrates 63 held in the holder trees 61 can receive the heat coming from the heater 66. The apparatus represented in figure 6 can also comprise more than one surface treatment source 65.

Preferably, a shutter system according to the present invention is arranged as a part of the carousel (e.g. arranged to be adjusted on the base plate of the carrousel) so that for example the holder trees can be removed from the base plate of the carousel without to need to remove the shutter system.

Preferably, the shutter system can be removed from the base plate of the carousel. Preferably each shutter system of each holder tree can be operated separately.

The shutter system comprises more than one movable element, each movable shutter element can be moved independently.

Preferably, the shutter system and/or the movable shutter elements are made of nonmagnetic materials such as for example stainless steel.

Preferably, the shutter systems according to the present invention can be controlled during the execution of the one or more surface treatments in order to change the position of the movable shutter elements for operating in an open position or closed or semi-open position many times during one process.

The shutter system should be arranged in the chamber so that it can be floated or grounded during process.

A shutter system according to the present can be also designed in such a manner that it can cover for example only a part of the holder tree, for example the upper or the middle or the lower part.

In some cases it could be advantageously for apparatus according to the present invention to place a surface treatment source or a heating element in the middle of the carousel.

The use of an apparatus according to the present invention as vacuum coating apparatus (e.g. for deposition of films by means of physical vapor deposition methods) involves several advantages, such as:
- The chamber size in comparison with conventional coating apparatus can be reduced. Conventional surface treatments apparatus involving the use of at least one source for producing treatment agents are designed having a relative big space between source and substrate holding system, which is needed for arranging a shutter system in front of the source in order to avoid the flow of treatment agents from the source to the substrates, for example during the conditioning time after the activation of the source. Since these conventional shutter systems are usually placed in front of the treatment sources and require place for opening (e.g. in direction to the top, bottom or to a side of the chamber), the size of conventional deposition chambers has to be bigger.
- It is not necessary to execute more than one batch for coating substrates which require different coating thickness or different etching times, because it is possible to carry out only one batch with the different substrates in such a manner, that for example the etching time and film deposition time is adapted (e.g. reduced) for each kind of substrates by using a shutter system according to the present invention. For example, the shutter elements in one holder tree can be maintained open full time for treating the substrates which need maximum etching time and coating thickness, while the shutter elements in another holder tree can be maintained open only temporarily (for example during the half of the deposition time) for obtaining the half of the coating thickness, and similarly could be done when the requirement of time reduction are regarding etching process.
- A deposition of the multilayer films with different layer periods is possible in one batch if the shutter systems in the different holder trees are controlled accordingly.
- Since the time for pumping and heating is a significant portion of the process time, hence by using a coating apparatus with several holder trees, each one with a shutter system according to the present invention it is possible to increase the efficiency in the industrial production, because it is not necessary to execute more than one batch for conducting coating processes which only differ in coating thickness or etching time.

It is important to take into account that the mechanical stability of a shutter system might depend strongly on the construction of the shutter.

A concrete example of the magnitude of the increment of productivity by using a coating apparatus according to the present invention will be explained following. Normally in the production three different coating batches have to be carried out in order to coat substrates with the same coating but having three different coating thicknesses 1, 2 and 3. The time for pumping, heating, etching and cooling is usually the same for deposition processes for different coating thickness. The time consuming resulted by executing the three different coating batches is shown in figure 7. The total process time for all processes was 690 minutes.

By using an apparatus according to the present invention it is possible to arrange the substrates which need different coating systems in three different holder trees having independent shutter systems. In this manner, it is possible to coat the substrates with three coating thicknesses 1, 2 and 3 only in one coating batch which results in a total time consuming of 260 minutes. Thus, the use of a holding system having different holder trees, each one having an independent shutter system according to the present invention, enables significant improvement of the productivity of a coating apparatus.

## Claims

1. Treatment and/or coating apparatus comprising a treatment chamber, in which substrates 43/53/63 having a surface to be treated are arranged in at least one substrate holding system 3 placed inside of the chamber, wherein at least one source 5/45/55/65 for producing surface treatment agents is arranged in the interior of the chamber for carrying out one or more surface treatments on the substrates arranged in the holding system, wherein the substrate holding system comprises at least one shutter system 47/57/67 comprising at least one movable shutter element 1 to be arranged around of at least a portion of the holder system for shielding at least some of the substrates arranged in the holding system in such a manner that the surface of the shielded substrates cannot be treated during the execution of the one or more surface treatments or at least during a part of the execution of the one or more surface treatments because the movable shutter element interrupts at least partially or avoid completely the surface treatment of the shielded substrates, and wherein the at least one movable shutter element is a rotatable shutter element having a half tube form which allows covering at least an extension of 180° of the transversal section of the substrate holder system **characterized in that**:
the holder system comprises more than one holder tree 3/41/51/61 and each holder tree comprises a shutter system, preferably four holder trees, wherein the holder trees are arranged in a carrousel 40/50/60 which is arranged in the middle of the treatment chamber and wherein:
• the shutter system comprises two shutter elements, 1 and 1' each one of the shutter elements has a half tube form, and preferably each one of the shutter elements can cover an extension of 180 ° of the transversal section of the holder tree, so that it is possible to cover the holder tree completely, so that it is possible to cover 360 ° of the transversal section of the holder tree, and
• the at least one source is an arc or sputtering target placed in a lateral area of the chamber, and
• the holder tree can remain in front of the source and rotate on its own axis, such that the held substrates can be only temporarily in front of the target during the rotation of the holder tree.

2. Apparatus according to any of the claims 1 **characterized in that** each movable element of at least one shutter system can be moved independently.

3. Apparatus according to any of the claims 1 to 2 **characterized in that** one or more of the shutter systems are arranged being adjusted to the carousel or being a part of the carrousel.

4. Apparatus according to claim 3 **characterized in that** one or more of the shutter systems are adjusted on the base plate of the carrousel.

5. Apparatus according to claim 4 **characterized in that** one or more holder trees can be removed from the base plate of the carousel without to need to remove the corresponding shutter system.

6. Apparatus according to claim 5 **characterized in that** one or more shutter systems can be removed from the base plate of the carousel.

7. Apparatus according to any of the previous claims **characterized in that** one or more shutter system and/or one or more movable shutter elements are made of nonmagnetic materials.

8. Apparatus according to claim 7 **characterized in that** one or more shutter system and/or one or more movable shutter elements are made of stainless steel.

9. Apparatus according to any of the previous claims **characterized in that** one or more of the shutter systems can be controlled during the execution of one or more surface treatments in order to change the position of the movable shutter elements for operating in an open position or closed or semi-open position at least one time, preferably many times during one process.

10. Apparatus according to any of the previous claims **characterized in that** one or more shutter systems are arranged in the chamber in such a manner, that they can be floated or grounded during the execution of the one or more surface treatment processes.

11. Apparatus according to any of the previous claims **characterized in that** one or more shutter systems can cover a part of the corresponding holder tree, e.g. the upper or the middle or the lower part.

## Patentansprüche

1. Behandlungs- und/oder Beschichtungsvorrichtung mit einer Behandlungskammer, in der Substrate mit einer zu behandelnden Oberfläche in mindestens einem innerhalb der Kammer angeordneten Substrathaltersystem angeordnet sind, wobei zur Durchführung einer oder mehrerer Oberflächenbehandlungen an den in dem Haltesystem angeordneten Substraten mindestens eine Quelle zur Herstellung von Oberflächenbehandlungsmitteln im Inneren der Kammer angeordnet ist, wobei das Substrathaltersystem mindestens ein Verschlusssystem umfasst, das mindestens ein bewegliches Verschlusselement umfasst, das um mindestens einen Teil des Haltersystems herum angeordnet wird, um mindestens einige der in dem Haltersystem angeordneten Substrate derart abzuschirmen, dass die Oberfläche der abgeschirmten Substrate während der Durchführung der einen oder mehrerer Oberflächenbehandlungen oder zumindest während eines Teils der Durchführung der einen oder mehrerer Oberflächenbehandlungen nicht behandelt werden kann, weil das bewegliche Verschlusselement die Oberflächenbehandlung der abgeschirmten Substrate zumindest teilweise unterbricht oder vollständig verhindert, und wobei das mindestens eine bewegliche Verschlusselement ein drehbares Verschlusselement mit einer Halbrohrform ist, die es ermöglicht, mindestens eine Erweiterung von 180° des Querschnitts des Substrathaltersystems abzudecken, **dadurch gekennzeichnet, dass**:
das Haltersystem mehr als einen Halterbaum umfasst und jeder Halterbaum ein Verschlusssystem umfasst, vorzugsweise vier Halterbäume, wobei die Halterbäume in einem Karussell angeordnet sind, das in der Mitte der Behandlungskammer angeordnet ist, und wobei:
• das Verschlusssystem zwei Verschlusselemente umfasst, wobei jedes der Verschlusselemente eine Halbrohrform aufweist und vorzugsweise jedes der Verschlusselemente eine Erweiterung von 180° des Querabschnitts des Halterbaums abdecken kann, so dass es möglich ist, den Halterbaum vollständig abzudecken, so dass es möglich ist, 360° des Querabschnitts des Halterbaums abzudecken, und
• die mindestens eine Quelle ein Lichtbogen- oder ein Sputter-Target ist, das in einem seitlichen Bereich der Kammer platziert ist, und
• der Halterbaum vor der Quelle bleiben und sich um seine eigene Achse drehen kann, so dass sich die gehaltenen Substrate während der Drehung des Halterbaums nur vorübergehend vor dem Target befinden können.

2. Vorrichtung nach einem der Ansprüche 1, **dadurch gekennzeichnet, dass** jedes bewegliche Element von mindestens einem Verschlusssystem eigenständig bewegt werden kann.

3. Vorrichtung nach einem der Ansprüche 1 bis 2, **dadurch gekennzeichnet, dass** eines oder mehrere der Verschlusssysteme so angeordnet sind, dass sie an das Karussell angepasst sind oder Teil des Karussells sind.

4. Vorrichtung nach Anspruch 3, **dadurch gekennzeichnet, dass** eines oder mehrere der Verschlusssysteme an die Grundplatte des Karussells angepasst sind.

5. Vorrichtung nach Anspruch 4, **dadurch gekennzeichnet, dass** ein oder mehrere Halterbäume von der Grundplatte des Karussells entfernt werden können, ohne dass das entsprechende Verschlusssystem entfernt werden muss.

6. Vorrichtung nach Anspruch 5, **dadurch gekennzeichnet, dass** ein oder mehrere Verschlusssysteme von der Grundplatte des Karussells entfernt werden können.

7. Vorrichtung nach einem der vorhergehenden Ansprüche, **dadurch gekennzeichnet, dass** ein oder mehrere Verschlusssysteme und/oder ein oder mehrere bewegliche Verschlusselemente aus nichtmagnetischen Materialien hergestellt sind.

8. Vorrichtung nach Anspruch 7, **dadurch gekennzeichnet, dass** ein oder mehrere Verschlusssysteme und/oder ein oder mehrere bewegliche Verschlusselemente aus Edelstahl hergestellt sind.

9. Vorrichtung nach einem der vorhergehenden Ansprüche, **dadurch gekennzeichnet, dass** eines oder mehrere der Verschlusssysteme während der Durchführung einer oder mehrerer Oberflächenbehandlungen gesteuert werden können, um die Position der beweglichen Verschlusselemente mindestens einmal, vorzugsweise mehrmals während eines Prozesses, für den Betrieb in einer offenen oder geschlossenen Position oder halboffenen Position zu ändern.

10. Vorrichtung nach einem der vorhergehenden Ansprüche, **dadurch gekennzeichnet, dass** ein oder mehrere Verschlusssysteme so in der Kammer angeordnet sind, dass sie während der Durchführung des einen oder mehrerer Oberflächenbehandlungsprozesse gefloatet oder geerdet werden können.

11. Vorrichtung nach einem der vorhergehenden Ansprüche, **dadurch gekennzeichnet, dass** ein oder mehrere Verschlusssysteme einen Teil des entsprechenden Halterbaums abdecken können, z. B. den oberen oder den mittleren oder den unteren Teil.

## Revendications

1. Appareil de traitement et/ou de revêtement comprenant une chambre de traitement, dans laquelle des substrats ayant une surface à traiter sont disposés dans au moins un système de maintien de substrats qui est placé à l'intérieur de la chambre, au moins une source étant disposée à l'intérieur de la chambre pour produire des agents de traitement de surface afin d'effectuer un ou plusieurs traitements de surface sur les substrats disposés dans le système de maintien, le système de maintien de substrats comprenant au moins un système de fermeture qui comprend au moins un élément de fermeture mobile qui est disposé autour d'au moins une partie du système de maintien pour protéger au moins certains des substrats disposés dans le système de maintien de telle manière que la surface des substrats protégés ne puisse pas être traitée pendant l'exécution d'un ou plusieurs traitements de surface ou au moins pendant une partie de l'exécution de l'un ou plusieurs traitements de surface parce que l'élément de fermeture mobile interrompt au moins partiellement ou évite complètement le traitement de surface des substrats protégés, et le du moins un élément de fermeture mobile étant un élément de fermeture rotatif ayant la forme d'un demi-tube qui permet de couvrir au moins une extension de 180° de la section transversale du système de maintien des substrats, **caractérisé en ce que**:
le système de maintien comprend plus d'un arbre de support et chaque arbre de support comprend un système de fermeture, de préférence quatre arbres de support, les arbres de support étant disposés dans un carrousel qui est disposé au milieu de la chambre de traitement et:
• le système de fermeture comprenant deux éléments de fermeture, chacun des éléments de fermeture a la forme d'un demi-tube, et de préférence chacun des éléments de fermeture peut couvrir une extension de 180° de la section transversale de l'arbre de support, de sorte qu'il est possible de couvrir complètement l'arbre de support, de sorte qu'il est possible de couvrir 360° de la section transversale de l'arbre de support, et
• la du moins une source est une cible d'arc ou de pulvérisation placée dans une zone latérale de la chambre, et
• l'arbre de support peut rester devant la source et tourner sur son propre axe, de sorte que les substrats maintenus ne peuvent être que temporairement devant la cible lors de la rotation de l'arbre de support.

2. Appareil selon l'une quelconque des revendications 1 **caractérisé en ce que** chaque élément mobile d'au moins un système de fermeture peut être déplacé indépendamment.

3. Appareil selon l'une quelconque des revendications 1 à 2, **caractérisé en ce qu'**un ou plusieurs des systèmes de fermeture sont disposés de manière ajustée au carrousel ou faisant partie du carrousel.

4. Appareil selon la revendication 3 **caractérisé en ce qu'**un ou plusieurs des systèmes de fermeture sont ajustés à la plaque de base du carrousel.

5. Appareil selon la revendication 4 **caractérisé en ce qu'**un ou plusieurs arbres de support peuvent être retiré(s) de la plaque de base du carrousel sans qu'il soit nécessaire de retirer le système de fermeture correspondant.

6. Appareil selon la revendication 5 **caractérisé en ce qu'**un ou plusieurs systèmes de fermeture peuvent être retiré(s) de la plaque de base du carrousel.

7. Appareil selon l'une quelconque des revendications précédentes **caractérisé en ce qu'**un ou plusieurs systèmes de fermeture et/ou un ou plusieurs éléments de fermeture mobiles sont réalisés en matériaux non magnétiques.

8. Appareil selon la revendication 7 **caractérisé en ce qu'**un ou plusieurs systèmes de fermeture et/ou un ou plusieurs éléments de fermeture mobiles sont réalisés en acier inoxydable.

9. Appareil selon l'une quelconque des revendications précédentes **caractérisé en ce qu'**un ou plusieurs des systèmes de fermeture peuvent être commandés pendant l'exécution d'un ou plusieurs traitements de surface afin de changer la position des éléments de fermeture mobiles au moins une fois, de préférence plusieurs fois pendant un processus, pour le fonctionnement en position ouverte ou en position fermée ou semi-ouverte.

10. Appareil selon l'une quelconque des revendications précédentes, **caractérisé en ce qu'**un ou plusieurs systèmes de fermeture sont disposés dans la chambre de telle manière à pouvoir flotter ou être mis à terre pendant l'exécution de l'un ou plusieurs processus de traitement de surface.

11. Appareil selon l'une quelconque des revendications précédentes, **caractérisé en ce qu'**un ou plusieurs systèmes de fermeture peuvent couvrir une partie de l'arbre de support correspondant, par exemple la partie supérieure ou moyenne ou la partie inférieure.
